# EUROPEAN PATENT APPLICATION

(11) **EP 4 524 621 A1**
(43) Date of publication of application: **19.03.2025**
(21) Application number: 23803324.5
(22) Date of filing: 12.04.2023
(51) Int. Cl.: G02B 3/00, G02B 1/111, G02B 5/18, H01L 27/146, H01L 31/0232

(54) **MICROLENS ARRAY AND SOLID-STATE IMAGING ELEMENT**

(30) Priority: 10.05.2022 JP 2022077426
(71) Applicant: Toppan Holdings Inc., Tokyo 110-0016 (JP)
(72) Inventor: TOMIOKA, Shungo, Tokyo 110-0016 (JP)
(74) Representative: Hoffmann Eitle
(86) International application number: PCT/JP2023/014873
(87) International publication number: WO 2023/218842

(57) **Abstract**

A microlens array (30) in which a plurality of microlenses (31) are disposed in order includes a low refractive index layer (60) that contains a hollow filler and a medium and is formed on the plurality of microlenses, and that has a lower refractive index than the refractive index of the plurality of microlenses. The proportion of white pixels in a binarized plan view image of the low refractive index layer is 76% or less.

## Description

### [Technical Field]

The present invention relates to a microlens array and a solid-state imaging device including this microlens array.

The present application claims the benefit of priority from Japanese Patent Application No. 2022-077426 filed May 10, 2022, the contents of which are incorporated herein by reference.

### [Background Art]

Distance image sensors that can be incorporated in thin, portable cellular phones and include a solid-state imaging device are known.

For example, Patent Literature 1 describes a photoelectric conversion substrate including a plurality of photoelectric conversion portions and a microlens array provided on the photoelectric conversion portions. The microlens array has a function of condensing incident light on each of the photoelectric conversion portions.

For the microlenses that constitute the microlens array, a material having a relatively high refractive index is used to increase the light condensing rate. However, microlenses having a high refractive index cause loss of incident light due to reflection occurring at the interface between the microlenses and air.

For mitigating this loss, it is known to provide on the microlenses an antireflection layer formed of a material having a lower refractive index than the refractive index of the material for the microlenses.

Patent Literature 2 describes, as a low refractive index material, a material obtained by adding silica particulates having voids therein to a fluorine-containing siloxane resin. The hollow silica has almost the identical refractive index as air, and therefore provides an advantage of enabling the refractive index of the formed antireflection layer to be relatively easily adjusted by changing the content of the hollow silica.

### [Citation List]

### [Patent Literatures]

[PTL 1] JP 2019-195051 A
[PTL 2] JP 5668276 B

### [Summary of the Invention]

### [Technical Problem]

Along with expansion of uses and structural complication of the solid-state imaging device, cases in which other layers are formed on the antireflection layer are recently increasing. For example, in a 3D sensor including the solid-state imaging device, a diffraction grating pattern is sometimes formed on the antireflection layer.

A general diffraction grating pattern is formed by exposure, development, and patterning of a photosensitive resin layer. The inventor has found that when such a pattern is formed on an antireflection layer containing a hollow silica filler, problems such as generation of cracks and stains are sometimes caused. The detail of these problems is described later. The inventor has clarified the cause of these problems, and has completed the present invention.

The present invention aims at providing a microlens array including a low refractive index layer to suppress interfacial reflection and enabling another layer to be suitably formed on the low refractive index layer.

### [Solution to Problem]

A first aspect of the present invention is a microlens array in which a plurality of microlenses are disposed in order.

This microlens array includes a low refractive index layer that contains a hollow filler and a medium and is formed on the plurality of microlenses, and that has a lower refractive index than the refractive index of the plurality of microlenses.

The proportion of white pixels in a binarized plan view image of the low refractive index layer is 76% or less.

A second aspect of the present invention is a solid-state imaging device including the microlens array according to the first aspect.

### [Advantageous Effects of the Invention]

The present invention can provide a microlens array including a low refractive index layer to suppress interfacial reflection and enable another layer to be suitably formed on the low refractive index layer.

### [Brief Description of the Drawings]

Fig. 1 is a schematic cross-sectional view of a solid-state imaging device according to one embodiment of the present invention.
Fig. 2 is a diagram showing one process of the production of the solid-state imaging device shown in Fig. 1.
Fig. 3 is a diagram showing one process of the production of the solid-state imaging device shown in Fig. 1.
Fig. 4 is a diagram showing one process of the production of the solid-state imaging device shown in Fig. 1.
Fig. 5 is a diagram of a face-centered cubic lattice structure.
Fig. 6 is a scanning electron microscope (SEM) image of a low refractive index layer.
Fig. 7 is a binarized image of the SEM image shown in Fig. 6.
Fig. 8 is a binarized image shown in Fig. 7 but having noise removed therefrom.

### [Description of Embodiment]

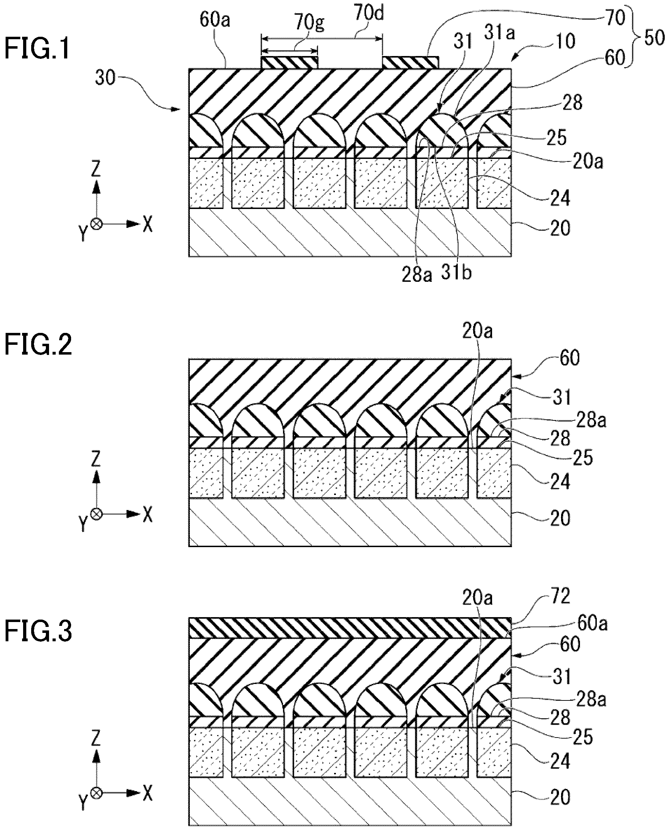

One embodiment of the present invention will be described below with reference to Figs. 1 to 8.

Fig. 1 is a schematic cross-sectional view of a solid-state imaging device 10 according to the present embodiment. The solid-state imaging device 10 includes a substrate 20, a CMOS image sensor 24, a color filter 28, and a microlens array 30, and, as a whole, functions as a distance image sensor.

The substrate 20 is, for example, a silicon (Si) substrate. The material for the substrate 20 is, for example, Si, but is not particularly limited as long as it is a material that includes a pixel and a light receiving element of the CMOS image sensor 24 and the like and can provide electrical functions to these pixel and light receiving element. Hereinafter, the thickness direction of the substrate 20 is defined as a Z direction, and the direction from the interior of the substrate 20 toward a surface 20a in the Z direction is defined as the "front". One direction parallel with the surface 20a and perpendicular to the Z direction is defined as an X direction, and the direction parallel with the surface 20a and perpendicular to the X and Z directions is defined as a Y direction.

The solid-state imaging device 10 includes a plurality of CMOS image sensors 24. The plurality of CMOS image sensors 24 are aligned along each of the X and Y directions. By providing the plurality of CMOS image sensors 24 as described above, a pixel array of the solid-state imaging device 10 is constituted in the direction along the surface 20a of the substrate 20. The number of the CMOS image sensors 24 provided in the solid-state imaging device 10 is set as appropriate according to, for example, the use of the solid-state imaging device 10, and Fig. 1 and the like show at least a part of the CMOS image sensors 24.

The CMOS image sensors 24 are embedded on the surface-20a side of the substrate 20 in the Z direction. Light receiving surfaces 25 of the CMOS image sensors 24 are exposed from the substrate 20 and substantially the identical plane with the surface 20a. Fig. 1 and the like omit the illustration of detailed structure of the CMOS image sensors 24, but the detailed structure is the same as a known CMOS image sensor.

The color filter 28 is provided on (that is, on the front in the Z direction) each of the light receiving surfaces 25 of the CMOS image sensors 24. The color filter 28 has a function of allowing light having a wavelength range of any one of three primary light colors, red (R), green (G), and blue (B) to pass therethrough. The color that the color filter 28 allows to pass therethrough is determined as appropriate for each of the plurality of CMOS image sensors 24 according to, for example, the disposition of the plurality of CMOS image sensors 24.

The microlens array 30 is formed on the color filters 28, and includes a plurality of microlenses 31 disposed in order corresponding to the color filters 28, a low refractive index layer 60 formed on the microlenses 31, and a diffraction grating (functional layer) 70 formed on the low refractive index layer 60. Here, the phrase "a plurality of microlenses 31 disposed in order corresponding to the color filters 28" refers to the state in which a plurality of microlenses 31 are disposed respectively overlapping the plurality of color filters 28 in plan view.

The microlenses 31 are provided on surfaces 28a of the color filters 28 respectively provided on the CMOS image sensors 24. Each of the microlenses 31 is a so-called plano-convex lens having a bottom surface 31b and a lens surface 31a. The material for the microlenses 31 has a higher refractive index than at least the refractive index of air and the low refractive index layer 60. Particularly, in order to increase the light condensing effect of the microlenses 31 through the difference in refractive index between the low refractive index layer 60 and the microlenses 31, the material for the microlenses 31 is preferably a high refractive index material having a refractive index of, for example, about 1.6. The curvature and the shape of the lens surface 31a are designed as appropriate according to, for example, the refractive index in visible wavelengths of the material for the microlenses 31. In addition, the microlenses 31 are formed and disposed so as to converge light, which is incident from the front in the Z direction toward the direction opposite to the front in the Z direction, into the CMOS image sensors 24 via the color filters 28 provided under (that is, the rear in the Z direction) the microlenses 31. Here, the plurality of microlenses 31 may be regarded as having an identical refractive index.

The low refractive index layer 60 has a surface 60a formed thereon for providing a diffraction grating 70 in front in the Z direction of the microlenses 31. The low refractive index layer 60 physically buries the surface 20a of the substrate 20 exposed between mutually adjacent color filters 28 and microlenses 31 in plan view. The maximum thickness of the low refractive index layer 60 (that is, the size in the Z direction between the surfaces 60a and 20a) is determined as appropriate according to, for example, the light path length required of the light incident from the front in the Z direction into the microlenses 31.

The "low" of the low refractive index layer 60 means that the low refractive index layer 60 has a lower refractive index than at least the refractive index of the microlenses 31. The difference in refractive index between the low refractive index layer 60 and the microlenses 31 can be increased the nearer the refractive index of the low refractive index layer 60 is to the refractive index of air. As a result of the increase, the refraction of light, incident from the front in the Z direction toward the direction opposite to the front in the Z direction, into the diffraction grating 70, is suppressed, and the course of the light incident into the diffraction grating 70 can thus be directed in a prescribed direction. This makes light well focused into the CMOS image sensors 24 by the microlenses 31, and the solid-state imaging device 10 can thus obtain desired optical characteristics. The refractive index of the low refractive index layer 60 is adjusted as appropriate in consideration of the type of low refractive index material described next and the content of the low refractive index material in the low refractive index layer 60.

The low refractive index layer 60 contains a hollow filler and a medium. The hollow filler and the medium have transparency in visible wavelengths, and have a total light transmittance of, for example, 90% or more with respect to light of visible wavelengths. The hollow filler contributes to lowering the refractive index of the low refractive index layer 60. The medium is present between particles of the hollow filler, bonds the particles of the hollow filler with each other, and stabilizes the low refractive index layer 60.

Examples of a suitable material for the hollow filler include silicon dioxide (silica, SiO₂). A hollow filler made from silica is cheap and has a high degree of transparency with respect to visible wavelengths and physical stability. Due to the hollow filler being in the low refractive index layer, air regions are scattered in the low refractive index layer 60. As a result of the scattering, the refractive index of the low refractive index layer 60 is lowered, and approaches the value of refractive index of air along with the increase of the content rate of the hollow filler.

The diffraction grating 70 is periodically provided with prescribed gaps in the X and Y directions on the surface 60a of the low refractive index layer 60. The light incident, from the front in the Z direction toward the direction opposite to the front in the Z direction, into the diffraction grating 70 is diffracted by the diffraction grating 70 in the vicinity of the surface 60a. That is, the light is, with respect to the normal along the Z direction, diffracted at a diffraction angle determined by the wavelength of the light and a pitch 70d of the diffraction grating 70 and travels in different directions depending on the wavelength. A size 70g and the pitch 70d in each of the X and Y directions of the diffraction grating 70 are designed as appropriate such that the light rays of the colors, red, green, and blue, among the light rays diffracted by the diffraction grating 70 as described above are applied to the microlenses 31 and the CMOS image sensors 24 overlapping, in the Z direction, the color filters 28 that respectively allow the light rays of wavelength ranges of the colors, red, green, and blue to pass therethrough.

The diffraction grating 70 has transparency at visible wavelengths, and has a total light transmittance of, for example, 90% or more with respect to light of visible wavelengths. The material for the diffraction grating 70 is not particularly limited as long as it is a material that has transparency with respect to light of visible wavelengths as described above, and can diffract the incident light in a prescribed direction according to the wavelength of the incident light. When the diffraction grating 70 is formed by patterning and a photolithography method as described next, a material that further enables patterning is suitable as the material for the diffraction grating 70, and examples of such a material include a resin material containing an acrylic resin.

Next, one example of a method for producing the microlens array 30 is described.

First, a plurality of microlenses 31 aligned in the manner of a two-dimensional array is formed (step A). Examples of a method for forming the microlenses 31 include a method for applying, as a layer, a high refractive index material to be the microlenses 31 onto at least surfaces 28a of color filters 28, providing a photoresist layer on the high refractive index material layer, and transferring, by etching, a lens pattern made by heat fusion after a photolithography process to the lower layer, i.e., the high refractive index material layer.

In the step A, the plurality of microlenses 31 may be prepared, for example, by purchasing a lens sheet including a plurality of microlenses disposed in order.

Next, as shown in Fig. 2, a coating solution having a low refractive index material dispersed therein is applied so as to cover a surface 20a of a substrate 20 exposed between mutually adjacent color filters 28 and microlenses 31 in plan view, the low refractive index material containing a hollow filler and a medium (step B), and heat is applied to cure the coating solution and thereby remove the solvent (step C). Thereby, a low refractive index layer 60 formed of almost only the low refractive index material is formed.

Next, as shown in Fig. 3, a material 72 for a diffraction grating 70 is applied at a prescribed thickness to a surface 60a of the low refractive index layer 60. As described above, the material 72 is a material that can realize the optical characteristics required of the diffraction grating 70, and that has photosensitivity enabling patterning, and the material 72 is, for example, a resin material such as an acrylic resin.

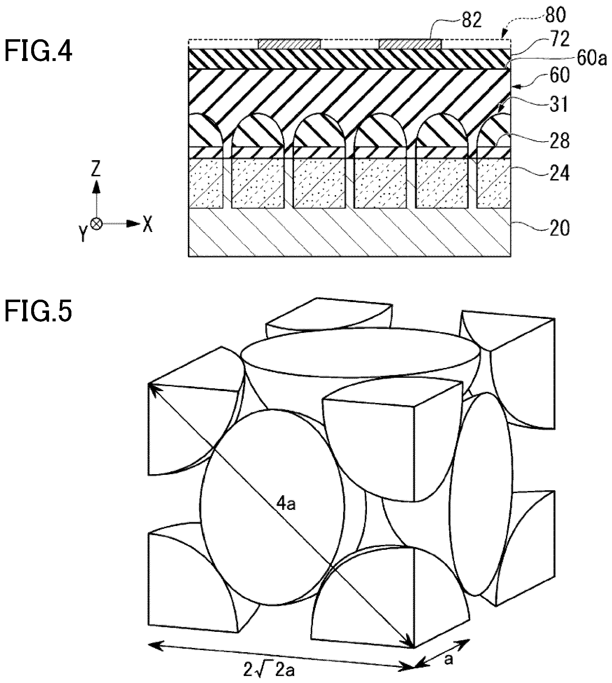

Subsequently, as shown in Fig. 4, a photomask 80 is disposed with gaps between the photomask 80 and the material 72 on (that is, the front in the Z direction) the material 72 coating the surface 60a of the low refractive index layer 60. The photomask 80 has formed therein the same pattern as the diffraction grating 70, and is, as shown in, for example, Fig. 3, provided with a light-shielding material 82 such as chromium (Cr) in only a part in which the diffraction grating 70 is formed in the X and Y directions. In the photomask 80, a part other than the light-shielding material 82 is formed of, for example, quartz (SiO₂) and allows light (for example, UV light) during pattern transfer in the photolithography process to pass therethrough in the Z direction.

Subsequently, in the setting shown in Fig. 4, patterning of the material is performed using the photomask 80. That is, the material 72 is exposed from the front in the Z direction of the photomask 80 toward the direction opposite to the front in the Z direction, and the pattern of the photomask 80 is transferred to the material 72. By this step, the material 72 is exposed except for the part overlapping the light-shielding material 82 in the Z direction. By removing the photomask 80 from the material 72, and removing the material 72 at the exposed part using an appropriate chemical or the like, the diffraction grating 70 is formed on the surface 60a of the low refractive index layer 60 as shown in Fig. 1. By performing the steps described above, a solid-state imaging device 10 shown in Fig. 1 and including a microlens array 30 is produced.

In the process of forming the low refractive index layer 60 on the microlenses 31 and further forming the diffraction grating 70 on the low refractive index layer 60 as described above, the inventor has encountered troubles of cracking occurring in the layer of the material 72 and the diffraction grating 70 completed. Due to the occurrence of many cracks, there has been a phenomenon in which the layer formed on the low refractive index layer 60 become peeled. There also have been circumstances in which a large amount of staining occurs on the low refractive index layer 60 in plan view, impairing the appearance and affecting the performance as a sensor.

As a result of various studies by the inventor, it has been considered that the cracks are attributable not to the quality or the like of the material 72, but highly probably attributable to the low refractive index layer 60. The inventor has, in light of this probability, studied the composition of the low refractive index layer by variously changing the composition, and found that the disposition aspect of the filler in the low refractive index layer is greatly attributable to the troubles.

There is an upper limit to the amount of the filler increased in the low refractive index layer. In the upper-limit state, particles of the filler are in contact with each other and cannot move relative to each other. The basic shape of the filler is substantially spherical, and therefore, in the upper-limit state, the filler is considered to have a disposition close to a face-centered cubic lattice structure shown in Fig. 5.

When a coating solution is prepared by dispersing a material for the low refractive index layer in a solvent, the solvent infiltrates into the hollow filler. This is because silica constituting the shells of the hollow filler is relatively porous.

The number of particles of the hollow filler that are partially exposed without being covered with the medium is increased on the surface of the low refractive index layer formed, along with the increase of the amount of the hollow filler in the material for the low refractive index layer. In the process in which the coating solution is dried into the low refractive index layer, the solvent having infiltrated into the hollow filler evaporates and is lost from the particles of the hollow filler exposed on the surface. The solvent is presumed to be lost not only from the exposed particles of the hollow filler, but also from particles of the hollow filler which are in contact with the exposed particles of the hollow filler and are positioned in the layer, through the porous shells.

There is no particular problem with this evaporation when no other layer is formed on the low refractive index layer. However, when another layer is formed on the low refractive index layer, a coating solution or the like for forming the layer is applied onto the low refractive index layer. During application, the solvent contained in the coating solution for the other layer enters into the exposed particles of the hollow filler.

Thereafter, when heat is applied to complete the other layer, the solvent which entered into the hollow filler is evaporated but there is almost no way for the vaporized solvent to escape because the top of the low refractive index layer is covered with the other layer. It is considered that as a result of this situation, when the amount of the vaporized solvent trying to escape reaches a certain level or more, the vaporized solvent causes cracks and thus damages or peels the upper layer. Further, a part of the solvent left in the filler becomes one of the causes of generating stains.

A main factor of the phenomenon described above is particles of the filler being in contact with each other. Therefore, by setting the content of the filler so that the disposition aspect of the filler in the low refractive index layer does not become the face-centered cubic lattice structure described above, the reduction of cracks and stains can be expected.

However, while the face-centered cubic lattice structure is formed, provided that all the constituent spheres are true spheres having identical dimensions (for example, the example shown in Fig. 5 is true spheres having a radius a), the actual filler is spherical but is less likely to be truly spherical, and further the particles of the filler are varied in dimension.

Therefore, it is actually very difficult to find an optimal content of the filler that makes the low refractive index layer have as low a refractive index as possible, and that can prevent the filler from being arranged in the face-centered cubic lattice structure.

As a result of conducting a further study, the inventor has found that by evaluation using a plan view image of the low refractive index layer, it is possible to simply determine whether the filler in the low refractive index layer has a disposition close to that of a face-centered cubic lattice structure that easily causes cracking and stains. The procedure will be described below.

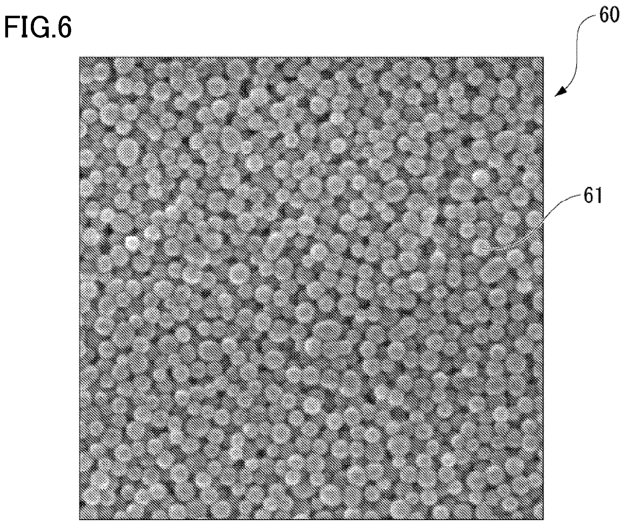

First, as shown in Fig. 6, a plan view image of the low refractive index layer 60 is acquired by a scanning electron microscope (SEM). It is observed in the acquired plan view image that a portion where the filler 61 is present tends to be bright, and a portion where the filler 61 is not present tends to be dark.

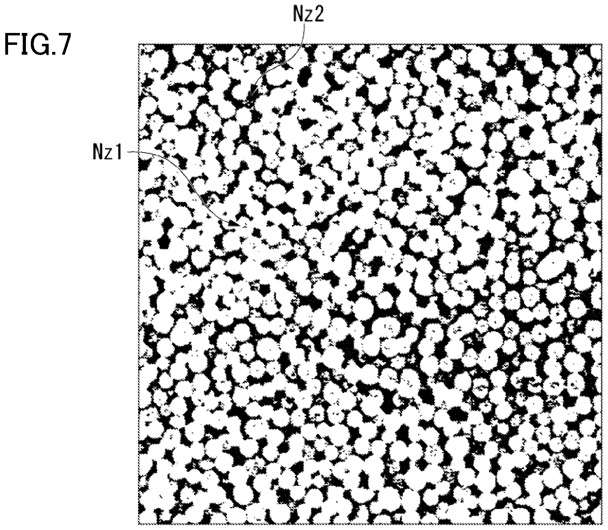

Next, this plan view image is subjected to a binarization process, and a binarized plan view image of the low refractive index layer 60 shown in Fig. 7 is acquired. As a binarization algorithm, various known algorithms can be used, and, for example, Otsu's binarization (discriminant analysis method) can suitably be used.

The binarized plan view image shown in Fig. 7 is roughly sorted into the portion where the filler is present and the portion where the filler is not present, but a small amount of noise is present in each of the portions. That is, the portion where the filler is present includes a small black noise area Nz1, and the portion where the filler is not present includes a small white noise area Nz2.

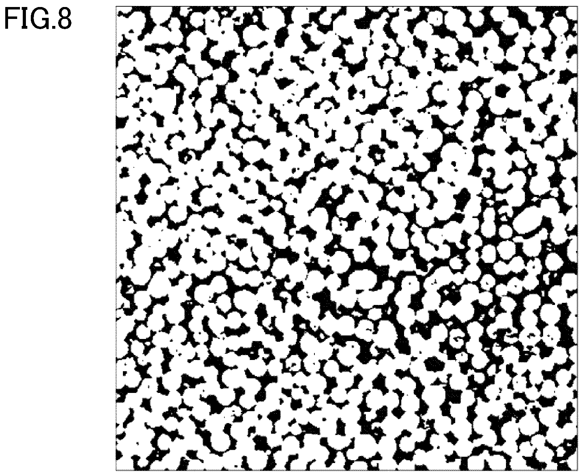

These noise areas are obstacles for accurately detecting the area of each of the portions, and therefore removed using a filter. As the filter, for example, a 3 x 3 median filter can suitably be used. Fig. 8 shows a binarized plan view image having noise removed therefrom with a 3 x 3 median filter.

Study by the inventor has clarified that the proportion of white pixels in the binarized plan view image having noise of the low refractive index layer removed therefrom is a good index indicating the amount and the disposition aspect of the filler contained in the low refractive index layer.

A plurality of samples of the low refractive index layer with various contents of a silica filler having an average particle size of 60 nm were prepared. Plan view images of the samples were acquired by SEM and processed by Otsu's binarization and with a 3 x 3 median filter, and binarized plan view images having noise removed therefrom were thus acquired. After the acquisition of the SEM images, a material for the diffraction grating was applied onto the low refractive index layer, and the presence or absence of occurrence of staining was checked by visual inspection. Table 1 shows the results.

**[Table 1]**

| | Proportion of white pixels (%) | Occurrence of stains |
|---|---|---|
| Sample 1 | 67.7 | None |
| Sample 2 | 69.2 | None |
| Sample 3 | 70.4 | None |
| Sample 4 | 72.6 | None |
| Sample 5 | 74.1 | None |
| Sample 6 | 75.3 | None |
| Sample 7 | 76.9 | Generated |
| Sample 8 | 82.1 | Generated |
| Sample 9 | 84.2 | Generated |
| Sample 10 | 86.5 | Generated |

As shown in Table 1, when the proportion of white pixels in the binarized plan view image having noise removed therefrom of the low refractive index layer was 76% or less, occurrence of staining was not observed. Thus, it has been shown that the proportion of white pixels is a suitable index for preventing the generation of staining and cracking. In Table 1, the low refractive index layers of the samples that did not have staining occur had a refractive index of 1.27 or more, and it has been shown that both a sufficiently low refractive index and prevention of the occurrence of staining and cracking can be achieved by setting the proportion of white pixels to 67% or more. From the viewpoint of obtaining a sufficient difference in refractive index between the low refractive index layer and the microlenses, the low refractive index layer preferably has a refractive index of 1.35 or less.

In Table 1, the samples 1 to 10 are put in numerical order of the proportion of white pixels but not in order of the content of the filler. Therefore, it has been shown that the proportion of white pixels is an independent index from the content of the filler in the low refractive index layer.

Heretofore, one embodiment of the present invention has been described in detail. However, the present invention is not limited to a specific embodiment, and includes modifications, combinations, and the like of the configurations without departing from the spirit of the present invention. Hereinafter, some modification examples will be described, but these examples are not all of the modifications and other modifications are also applicable. Two or more of these modifications may be combined as appropriate.

The embodiment described above has shown an on-chip solid-state imaging device including a color filter directly formed on a substrate, but the application range of the technical idea of the present invention is not limited to the on-chip solid-state imaging device, and the technical idea is widely applicable to a microlens array that includes a low refractive index layer formed on microlenses and containing a hollow filler, and that includes another layer further formed on the low refractive index layer. Therefore, the technical idea is also applicable to, for example, a lens sheet to be disposed on an organic EL (OLED).

An organic EL is sometimes covered with a cover layer such as glass. In this case, when microlenses are formed on the organic EL, peeling can be caused between the microlenses and the cover layer due to the unevenness of the microlenses. Therefore, a low refractive index layer is preferably provided between the microlenses and the cover layer. In this case, a layer structure is formed that includes the organic EL, a color filter, the microlens array (microlenses and a low refractive index layer) according to the present invention, and the cover layer such as glass stacked in this order. The generation of staining and cracking can be suppressed also in this case by employing the present invention.

The functional layer formed on the low refractive index layer is not also limited to the diffraction grating described above, and the technical idea of the present invention is applicable to any layer, such as an antiglare layer and a stain-resistant layer, formed using a coating solution containing a solvent. The cover layer described above is not a layer formed using a coating solution, but is one aspect of the functional layer.

The material of the hollow filler is not also limited to silica, and a resin filler and the like are also usable. However, the technical idea of the present invention is particularly effective when the hollow filler is a silica filler or the like including porous shells.

### [Industrial Applicability]

The present invention can provide a microlens array including a low refractive index layer to suppress interfacial reflection and enable another layer to be suitably formed on the low refractive index layer.

### [Reference Signs List]

- 10: Solid-state imaging device
- 30: Microlens array
- 31: Microlens
- 60: Low refractive index layer
- 70: Diffraction grating (functional layer)

## Claims

1. A microlens array in which a plurality of microlenses are disposed in order, the microlens array comprising
a low refractive index layer that contains a hollow filler and a medium and is formed on the plurality of microlenses, and that has a lower refractive index than a refractive index of the plurality of microlenses, wherein
a proportion of white pixels in a binarized plan view image of the low refractive index layer is 76% or less.

2. The microlens array according to claim 1, wherein
the proportion of white pixels is 67% or more.

3. The microlens array according to claim 1, further comprising a functional layer formed on the low refractive index layer.

4. The microlens array according to claim 1, wherein
the hollow filler is made from silica.

5. A solid-state imaging device comprising the microlens array according to any one of claims 1 to 4.
